(19) **Europäisches Patentamt**
**European Patent Office**
**Office européen des brevets**

(11) **EP 3 159 938 A1**

(12) **EUROPEAN PATENT APPLICATION**
published in accordance with Art. 153(4) EPC

(43) Date of publication:
26.04.2017 Bulletin 2017/17

(51) Int Cl.:
*H01L 31/055* (2014.01)     *H01L 31/048* (2014.01)
*H01L 31/0747* (2012.01)

(21) Application number: **15810544.5**

(22) Date of filing: **25.05.2015**

(86) International application number:
**PCT/JP2015/002623**

(87) International publication number:
**WO 2015/194096 (23.12.2015 Gazette 2015/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **20.06.2014 JP 2014127156**

(71) Applicant: **Panasonic Intellectual Property Management Co., Ltd.**
**Osaka-shi, Osaka 540-6207 (JP)**

(72) Inventors:
• **IRIKAWA, Junpei**
**Osaka 540-6207 (JP)**
• **IMADA, Naoto**
**Osaka 540-6207 (JP)**

(74) Representative: **Müller-Boré & Partner Patentanwälte PartG mbB**
**Friedenheimer Brücke 21**
**80639 München (DE)**

(54) **SOLAR CELL MODULE AND METHOD FOR MANUFACTURING SOLAR CELL MODULE**

(57)     This solar cell module (10) is provided with: a solar cell (11); a first protection member (12) that is arranged on the light-receiving surface side of the solar cell (11); a second protection member (13) that is arranged on the back surface side of the solar cell (11); and an encapsulant (14) that seals the solar cell (11). The encapsulant (14) comprises an encapsulant (14a) that is arranged between the solar cell (11) and the first protection member (12) and an encapsulant (14b) that is arranged between the solar cell (11) and the second protection member (13), and the encapsulant (14a) contains a wavelength conversion substance (30). This solar cell module (10) satisfies the condition of formula (1). $EQE(\lambda_2) \times (1 - 0.46n^{-2.8}) \times \eta \geq EQE(\lambda_1)$ (1) formula (1)

FIG. 2

**Description**

TECHNICAL FIELD

The present disclosure relates to a solar cell module and a method for manufacturing the solar cell module.

BACKGROUND

There have been known solar cell modules that are provided with wavelength conversion substances for absorbing light having particular wavelengths and converting the wavelengths. Such a solar cell module can convert incident light in a wavelength region that makes a small contribution to power generation into light in a wavelength region that makes a large contribution to power generation. For example, Patent Document 1 discloses a solar cell module provided with a base-surface wavelength conversion film which converts light in a wavelength region that has poor photoelectric conversion efficiency in a photoelectric conversion layer into light in a wavelength region that has good photoelectric conversion efficiency.

CITATION LIST

PATENT LITERATURE

PATENT DOCUMENT 1: WO 2011/155614

SUMMARY

Whole light absorbed by wavelength conversion substances is not incident on a solar cell. For example, a part of absorbed light is not subjected to wavelength conversion, because the internal quantum efficiency of the wavelength conversion substances is not 100%. In addition, since wavelength conversion substances emit light in an isotropic manner, a part of light having been subjected to wavelength conversion travels in a direction opposite to solar cells, and passes through a module to the outside. Therefore, this light loss needs to be considered in configuring a solar cell module. Otherwise, the utilization efficiency of incident light cannot be sufficiently improved, and the photoelectric conversion efficiency may be deteriorated.

An aspect of the solar cell module according to the present disclosure includes: a solar cell; a first protection member that is arranged on a light-receiving surface side of the solar cell; a second protection member that is arranged on a back surface side of the solar cell; an encapsulant that includes a first encapsulant arranged between the solar cell and the first protection member, and a second encapsulant arranged between the solar cell and the second protection member and that seals the solar cell; and a wavelength conversion substance that is contained in the first encapsulant and that absorbs light having a particular wavelength and converts the wavelength, wherein the condition of formula 1 is satisfied,

$$[\text{Formula 1}]\ \text{EQE}(\lambda_2) \times (1 - 0.46\text{n}^{-2.8}) \times \eta \geq \text{EQE}(\lambda_1),$$

where $\text{EQE}(\lambda_1)$ represents an external quantum efficiency of the module at the absorption long-wavelength edge ($\lambda_1$) of the wavelength conversion substance, $\text{EQE}(\lambda_2)$ represents an external quantum efficiency of the module at the emission peak wavelength ($\lambda_2$) of the wavelength conversion substance, n represents a refractive index of the first encapsulant, and $\eta$ represents a quantum efficiency of the wavelength conversion substance.

An aspect of a method for manufacturing a solar cell module according to the present disclosure includes: a first step of preparing a solar cell, a first protection member, and a second protection member; a second step of preparing first and second encapsulants that seal the solar cell; and a third step of sequentially overlapping and laminating the first protection member, the first encapsulant, the solar cell, the second encapsulant, and the second protection member, wherein a wavelength conversion substance that absorbs light having a particular wavelength and converts the wavelength is added to the first encapsulant, and in the second step, the wavelength conversion substance to be added to the first encapsulant is selected on the basis of formula 1.

According to the present disclosure, there can be provided a solar cell module having improved utilization efficiency of incident light and improved photoelectric conversion efficiency.

BRIEF DESCRIPTION OF DRAWINGS

[FIG. 1] FIG. 1 is a sectional view of a solar cell module which is an example of an embodiment.
[FIG. 2] FIG. 2 is an enlarged view of a part A in FIG. 1 (an electrode and a wiring material are omitted).
[FIG. 3] FIG. 3 is a diagram showing the external quantum efficiency of the solar cell module which is the example of the embodiment of the present disclosure.
[FIG. 4] FIG. 4 is a diagram showing the relation between the external quantum efficiency of the module and the absorption/emission wavelength of wavelength conversion substances, in the solar cell module which is the example of the embodiment.
[FIG. 5] FIG. 5 is a diagram showing the relation between the external quantum efficiency of the module and the absorption/emission wavelength of the wavelength conversion substances, in the solar cell module which is the example of the embodiment.
[FIG. 6] FIG. 6 is a sectional view of a solar cell module which is another example of the embodiment.
[FIG. 7] FIG. 7 is a diagram showing the relation between the external quantum efficiency of the module and the absorption/emission wavelength of wavelength conversion substances, in the solar cell module which is another example of the embodiment.

DETAILED DESCRIPTION

Hereinafter, an example of an embodiment is described in detail with reference to the drawings.

The drawings to which the embodiment refers are schematic, and the dimensional proportions and the like of components illustrated in the drawings may differ from their actual values. Specific dimension proportions or the like should be determined by considering the following description.

In the present specification, the term "light-receiving surface" of a solar cell module, a solar cell, or a photoelectric conversion unit means a surface on which light is mainly incident (more than 50 to 100% of light is incident on the light-receiving surface), and the term "back surface" means a surface opposite to the light-receiving surface. The expression "a second member is provided on a first member" etc. is not intended to apply only to a case where the first and second members are in direct contact with each other, unless a particular limitation is provided. That is, this expression includes a case where another member exists between the first and second members. In addition, regarding the expression "substantially **", the expression "substantially the same", as an example, is intended not only to mean "completely the same" but also to mean "considered to be substantially the same."

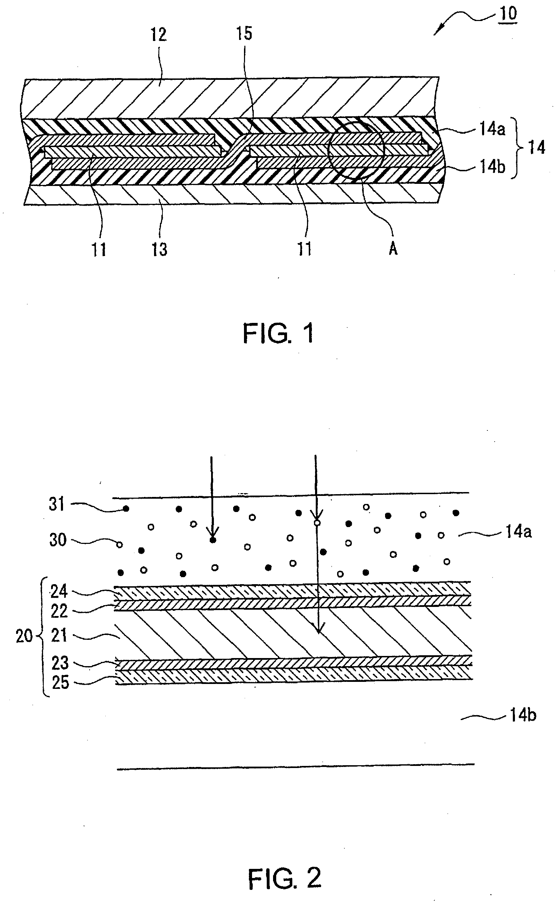

FIG. 1 is a sectional view of a solar cell module 10 which is an example of an embodiment.

As illustrated in FIG. 1, the solar cell module 10 is provided with solar cells 11, a first protection member 12 arranged on the light-receiving surface side of the solar cells 11, a second protection member 13 arranged on the back surface side of the solar cells 11, and an encapsulant 14 that is arranged between the protection members and that seals the solar cells 11. The encapsulant 14 includes an encapsulant 14a arranged between the solar cells 11 and the first protection member 12, and an encapsulant 14b arranged between the solar cells 11 and the second protection member 13. In the present embodiment, a plurality of the solar cells 11 are arranged between the protection members, and wiring materials 15 connecting the solar cells 11 to one another are provided.

The solar cell module 10 is provided with wavelength conversion substances 30 (see FIG. 2) that absorb light having a particular wavelength and convert the wavelength, the details of which are described later. The wavelength conversion substances 30 are contained in the encapsulant 14a. The wavelength conversion substances 30 may be contained in the encapsulant 14b. However, considering the utilization efficiency of the wavelength conversion substances 30, the concentration of the wavelength conversion substances 30 in the encapsulant 14a is preferably higher than the concentration of the wavelength conversion substances 30 in the encapsulant 14b.

As the first protection member 12, a member having translucency, such as a glass substrate, a resin substrate, or a resin film can be used. Of these members, a glass substrate is preferably used, from the viewpoint of fire resistance, durability, and the like. The thickness of the glass substrate is not limited to a particular value, but is preferably about 2 to 6 mm.

As the second protection member 13, a transparent member may be used similarly to the first protection member 12, or an opaque member may be used. For example, a resin film can be used as the second protection member 13. The resin film is not limited to a particular film, but is preferably a polyethylene terephthalate (PET) film. From the viewpoint of reducing moisture permeability, etc., in the resin film, an inorganic compound layer such as silica may be formed, or a metal layer such as aluminum may be formed in a case where light is not assumed to be incident on the back surface side. The thickness of the resin film is not limited to a particular value, but is preferably about 5 to 300 $\mu$m.

The encapsulant 14 serves to prevent the solar cells 11 from being in contact with moisture or the like. The encapsulant 14 is referred to as "sealing agent" in some cases. For example, the encapsulant 14 is formed by using two resin sheets, which form the encapsulants 14a and 14b, respectively, and performing laminate processes on the resin sheets. The thickness of the encapsulant 14 is not limited to a particular value, but the encapsulants 14a and 14b preferably each have a thickness of about 100 to 600 $\mu$m. The wavelength conversion substances 30 are added to at least the encapsulant 14a.

As the resin included in the encapsulant 14, resin having excellent contact properties with the protection members and the solar cells 11 and having low moisture permeability is preferable. More specifically, examples of the resin include olefin resin which is obtained by polymerizing at least one selected from $\alpha$-olefins having 2 to 20 carbon atoms (for example, polyethylene, polypropylene, and random or block copolymer of ethylene and another $\alpha$-olefin), ester resin (for example, polycondensation compound of polyol and polycarboxylic acid or an acid anhydride thereof/lower alkyl ester, etc.), urethane resin (for example, polyaddition material of polyisocyanate and an active hydrogen group-containing compound (diol, polyol triol, dicarboxylic acid, polycarboxylic acid, polyamine, polythiol, etc.)), epoxy resin (for example, a ring-opened polymer compound of polyepoxide, polyaddition material of polyepoxide and the above active hydrogen group-containing compound, etc.), and a copolymer of $\alpha$-olefin and vinyl carboxylate, acrylate ester, or vinyl monomer.

Of the above resins, olefin resin (in particular, polymer containing ethylene) and a copolymer of $\alpha$-olefin and vinyl carboxylate are particularly preferable. As the copolymer of $\alpha$-olefin and vinyl carboxylate, an ethylene-vinylacetate copolymer (EVA) is particularly preferable.

The wiring materials 15 are attached to electrodes of the solar cells 11 via adhesives, for example. In the present embodiment, the plurality of solar cells 11 are arranged on substantially the same plane. The solar cells 11 adjacent to each other are connected in series via the wiring material 15. Thus, a string of the solar cells 11 is formed. The wiring material 15 is bent, between the adjacent solar cells 11, in the thickness direction of the module, and is attached to the light-receiving surface of one solar cell 11 and the back surface of the other solar cell 11.

A solar cell panel is formed of the solar cells 11, the first protection member 12, the second protection member 13, and the encapsulant 14. The solar cell panel has a platelike body in which the string of the solar cells 11 is sandwiched between the protective materials, and has, for example, a substantially rectangular shape in plan view (when viewed in a direction perpendicular to the light-receiving surface). For example, a terminal box for pulling in an output wiring material is provided on the back side of the solar cell panel. The solar cell module 10 is preferably provided with a frame attachable to the end edge portion of the solar cell panel.

FIG. 2 is an enlarged view of a part A in FIG. 1, and illustrates the solar cell 11 and the encapsulant 14 in an enlarged manner.

As illustrated in FIG. 2, the solar cell 11 includes a photoelectric conversion unit 20 which generates carriers upon receiving solar light. The photoelectric conversion unit 20 has, as an electrode which collects generated carriers, a light-receiving surface electrode formed on the light-receiving surface of the photoelectric conversion unit 20, and a back surface electrode formed on the back surface (both electrodes are unillustrated). However, the structure of the solar cell 11 is not limited to this. For example, the solar cell 11 may have a structure in which an electrode is formed only on the back surface of the photoelectric conversion unit 20. The back surface electrode is preferably formed to have a larger area than the light-receiving surface electrode. The surface having a larger electrode area (or the surface on which the electrode is formed) is considered the "back surface" of the solar cell 11.

The electrode is preferably formed of a conductive filler and a binder resin which binds the filler. As the conductive filler, there can be used, for example, metal particles such as silver (Ag), copper (Cu), and nickel (Ni), or carbon, or a mixture thereof. As the binder resin, there can be used, for example, curable resin obtained by adding, as needed, a curing agent to epoxy resin, silicone resin, urethane resin, or the like. Of these, Ag particles and epoxy resin are particularly preferably used as the conductive filler and the binder resin, respectively.

For example, the photoelectric conversion unit 20 has a semiconductor substrate 21, amorphous semiconductor layers 22, 23 formed on the substrate, and transparent conductive layers 24, 25 formed on the amorphous semiconductor layers. Examples of the semiconductor included in the substrate 21 include crystalline silicon (c-Si), gallium arsenide (GaAs), and Indium phosphide (InP). Examples of the amorphous semiconductor included in the amorphous semiconductor layers 22, 23 include i-type amorphous silicon, n-type amorphous silicon, and p-type amorphous silicon. The transparent conductive layers 24, 25 are preferably made of transparent conductive oxide obtained by doping tin (Sn), antimony (Sb), or the like on metal oxide such as indium oxide ($In_2O_3$) and zinc oxide (ZnO).

More specifically, as an example, a structure in which an n-type single-crystal silicon substrate is used as the substrate 21 can be adopted. The photoelectric conversion unit 20 has, for example, a structure in which an i-type amorphous silicon layer, a p-type amorphous silicon layer, and the transparent conductive layer 24 are sequentially formed on the light-receiving surface of the n-type single-crystal silicon substrate, and an i-type amorphous silicon layer, a n-type amorphous silicon layer, and the transparent conductive layer 25 are sequentially formed on the back surface of the substrate. Alternatively, in some cases, a p-type amorphous silicon layer is formed on the back surface side of the n-type single-crystal silicon substrate and an n-type amorphous silicon layer is formed on the light-receiving surface side of the substrate. That is, the photoelectric conversion unit 20 has a junction (heterojunction) of semiconductors having different optical gaps.

The amorphous silicon layer is preferably formed by CVD. In a process for laminating an i-type amorphous silicon layer by CVD, raw material gas obtained by diluting silane gas ($SiH_4$) with hydrogen ($H_2$) is preferably used. For the n-type amorphous silicon layer, raw material gas, for example, obtained by adding phosphine ($PH_3$) to silane ($SiH_4$) and diluting the phosphine and silane with hydrogen ($H_2$) is used as raw material gas. For the p-type amorphous silicon layer, diborane ($B_2H_6$) is used as doping gas instead of phosphine ($PH_3$), for example. A heterojunction solar cell obtained by hybridizing the amorphous silicon and single-crystal silicon has a band gap of, for example, 1.7 eV. Hereinafter, the heterojunction solar cell is referred to as an "a-Si:H cell."

As illustrated in FIG. 2, the encapsulant 14a arranged on the light-receiving surface side of the solar cells 11 contains the wavelength conversion substances 30. The encapsulant 14a preferably further contains ultraviolet-absorbing substances 31. In the present embodiment, in the encapsulant 14a, the wavelength conversion substances 30 and the ultraviolet-absorbing substances 31 are substantially uniformly dispersed. However, non-uniform concentration distribution of both substances in the encapsulant 14a may be adopted such that the concentration of the wavelength conversion substances 30 in the vicinity of the first protection member 12 is higher than that in the vicinity of the solar cells 11 and the concentration of the ultraviolet-absorbing substances 31 in the vicinity of the first protection member 12 is lower than that in the vicinity of the solar cells 11.

The wavelength conversion substances 30, which absorb light having a particular wavelength and convert the wavelength, convert light in a wavelength region that makes a small contribution to power generation into light in a wavelength region that makes a large contribution to power generation, as described above. The wavelength conversion substances 30 preferably absorb ultraviolet rays and emit visible light. However, the wavelength conversion substances 30 may absorb visible light or infrared light. In general, the wavelength conversion substances 30 convert short-wavelength light into longer-wavelength light. However, the wavelength conversion substances 30 may emit light in up-conversion in which long-wavelength light is converted into shorter-wavelength light. The preferable absorption wavelength and the preferable conversion wavelength (emission wavelength), the details of which are described later, vary depending on the types of the solar cells 11.

The ultraviolet-absorbing substances 31, which selectively absorb ultraviolet rays, do not have a wavelength conversion function such as the function which the wavelength conversion substances 30 have. That is, the ultraviolet-absorbing substances 31 merely absorb ultraviolet rays and do not emit light. The ultraviolet-absorbing substances 31 do not absorb light having been converted, by the wavelength conversion substances 30, into light having a wavelength longer than the ultraviolet range. The ultraviolet-absorbing substances 31 suppress deterioration of the resin material included in the solar cell module 10 without impairing the photoelectric conversion efficiency. Thus, the ultraviolet-absorbing substances 31 preferably absorb ultraviolet rays having wavelengths of, in particular, 350 nm or less.

Specific examples of the ultraviolet-absorbing substance 31 include a benzotriazole compound, a benzophenone compound, a salicylate compound, a cyanoacrylate compound, a nickel compound, and a triazine compound. These compounds are inexpensive compared to the wavelength conversion substances 30. Thus, a highly functional product can be provided at low cost by using the wavelength conversion substances 30 and the ultraviolet-absorbing substances 31 in combination.

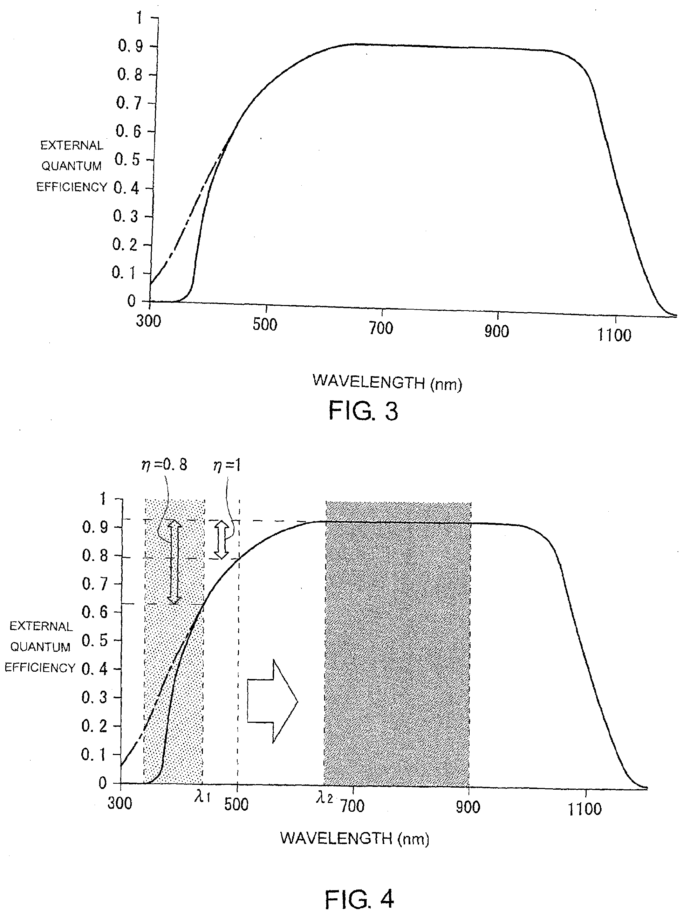

Here, the suitable combination of the solar cells 11 (a-Si:H cells) having the above heterojunction and the wavelength conversion substances 30 is described in detail, with reference to FIGS. 3 to 5.

FIG. 3 shows the external quantum efficiency (EQE) of a solar cell module 10z (in a state where no wavelength conversion substance 30 is contained) provided with the a-Si:H cells, with respect to wavelengths. The solid line represents the external quantum efficiency in a case where the ultraviolet-absorbing substances 31 are contained, and the alternate long and short dash line represents the external quantum efficiency in a case where no ultraviolet-absorbing substances 31 are contained (the same applies for FIGS. 4, 5, and 7). FIG. 3 shows the external quantum efficiency in a state where no wavelength conversion substances 30 are contained. In the long-wavelength region, compared to the absorption edge of the wavelength conversion substances 30, the external quantum efficiency does not vary depending on the presence or absence of the wavelength conversion substances 30 (that is, when the external quantum efficiency of the absorption edge is argued, the presence or absence of the wavelength conversion substances 30 is not considered).

The measurement condition of the external quantum efficiency is as follows.

- Device: Spectral sensitivity measurement device
- Measurement region, etc.: An area on which the solar cells are arranged is irradiated with light from the first protection member side. Measurement is performed under a condition where the number of incoming photons is fixed while the wavelength is being changed.

The external quantum efficiency of the solar cell module depends mainly on the structure (a heterojunction type, a diffusion type, etc.) and the component materials (a semiconductor included in the substrate, etc.) of the solar cell 11.

The solar cell module 10 preferably satisfies the condition of formula 1.

$$[\text{Formula 1}] \; EQE(\lambda_2) \times (1 - 0.46n^{-2.8}) \times \eta \geq EQE(\lambda_1),$$

where $EQE(\lambda_1)$ represents an external quantum efficiency of the solar cell module 10 at the absorption long-wavelength edge ($\lambda_1$) of the wavelength conversion substances 30, $EQE(\lambda_2)$ represents an external quantum efficiency of the solar cell module 10 at the emission peak wavelength ($\lambda_2$) of the wavelength conversion substances 30, n represents a refractive index (hereinafter, simply referred to as "refractive index of the encapsulant 14a") of the first encapsulant 14a at the emission peak wavelength of the wavelength conversion substances 30, and $\eta$ represents a quantum efficiency of the wavelength conversion substances 30. For example, the absorption long-wavelength edge ($\lambda_1$) is a wavelength at which the transmittance of the encapsulant 14a containing the wavelength conversion substances 30 is 85% or greater.

Formula 1 is obtained considering incident light loss which is caused by addition of the wavelength conversion substances 30. This incident light loss is expressed by $(1-0.46n^{-2.8}) \times \eta$. Hereinafter, $(1 - 0.46n^{-2.8}) \times \eta$ is abbreviated to "$\alpha$", in some cases. The quantum efficiency $\eta$ of the wavelength conversion substances 30 is obtained while considering loss which is caused because a part of light absorbed by the wavelength conversion substances 30 is not subjected to wavelength conversion. The value $0.46n^{-2.8}$ is a loss which is caused by light emission performed by the wavelength conversion substances 30 in an isotropic manner. That is, the loss is generated because a part of light having been subjected to wavelength conversion travels in a direction opposite to the solar cells 11 and passes through the module to the outside without being reflected toward the solar cells 11 by the first protection member 12 or the like. The loss is obtained from the result of calculation of the percentage of light confined in the module by using the Fresnel equations.

The solar cell module 10 satisfies the condition of formula 1, thereby increasing the external quantum efficiency at the absorption wavelengths of the wavelength conversion substances 30 and improving the utilization efficiency of incident light. That is, when the condition of formula 1 is satisfied, the effect of addition of the wavelength conversion substances 30 is larger than the loss caused by the addition of the substances. On the other hand, when the condition of formula 1 is not satisfied, the utilization efficiency of the wavelength conversion substances 30 is reduced. For example, when $EQE(\lambda_2) \times \alpha$, is greatly smaller than $EQE(\lambda_1)$, the loss caused by the addition of the wavelength conversion substances 30 is larger than the effect of the addition of the substances, thereby reducing the photoelectric conversion efficiency in some cases.

As shown in FIG. 3, in a case of the a-Si:H cells, the external quantum efficiency is high when the wavelength is within a range of 650 to 1000 nm. On the other hand, the external quantum efficiency is low when the wavelength is shorter than the wavelength of 650 nm or longer than the wavelength of 1000 nm. Accordingly, when the solar cells 11 are the a-Si:H cells, the absorption wavelengths of the wavelength conversion substances 30 are preferably less than 650 nm and the emission wavelength of the wavelength conversion substances 30 is preferably 650 to 1000 nm. Further, the absorption long-wavelength edge ($\lambda_1$) is preferably 350 to 500 nm, and the emission peak wavelength ($\lambda_2$) is not less than a value obtained by adding 20 nm to the long-wavelength edge ($\lambda_1$) but is 1000 nm or less, by considering the condition of formula 1. The emission peak wavelength ($\lambda_2$) is preferably within a range of 650 to 1000, nm at which the external quantum efficiency is maximum. However, the emission peak wavelength ($\lambda_2$) is particularly preferably within a range of 650 to 900 nm, in consideration of influences including the absorptivity or the back surface reflectivity of the encapsulant 14, reduction in Si absorption due to a thin substrate, free carrier absorption performed by the transparent conductive layers, and back passivation (none of them is illustrated).

In order to suppress deterioration of the component material (for example, the epoxy resin included in the electrodes) of the module due to absorbed ultraviolet rays, the wavelength conversion substances 30 preferably absorb at least a part of ultraviolet rays and convert the absorbed ultraviolet rays into light having a longer wavelength. In addition, when the wavelength conversion substances 30 absorb ultraviolet rays and convert the wavelength of the rays, the transparent conductive layers 24, 25, and the heterojunction layer are also suppressed from absorbing incident light. The converted wavelength (the emission wavelength) is preferably within a range of 650 to 1000 nm, as described above. That is, to configure the solar cell module 10, setting the emission peak wavelength ($\lambda_2$) within a range of 650 to 1000 nm is preferably followed by setting the absorption long-wavelength edge ($\lambda_1$) so as to satisfy the condition of formula 1.

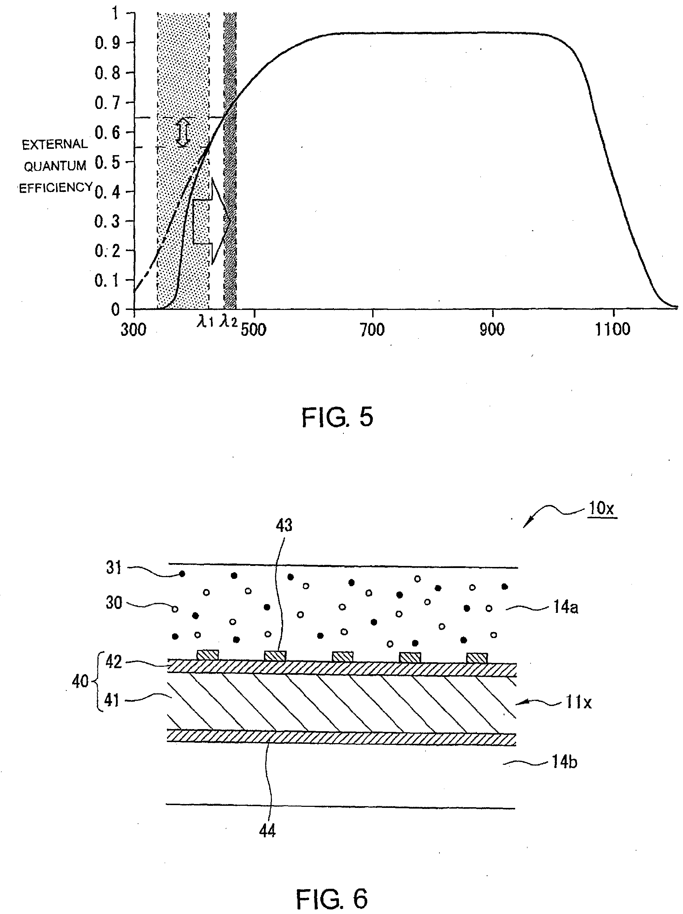

FIG. 4 is a diagram showing one specific example in which the solar cell module 10 provided with the a-Si:H cells satisfies the condition of formula 1 (the same applies for FIG. 5 which is described later). In the example shown in FIG. 4, the quantum efficiency $\eta$ of the wavelength conversion substances 30 contained in the encapsulant 14a is 0.8, and the refractive index n of the first encapsulant 14a is 1.5 (that is, $0.46n^{-2.8} = 0.15$). In addition, the absorption long-wavelength edge ($\lambda_1$) of the wavelength conversion substances 30 is 440 nm, and the emission peak wavelength ($\lambda_2$) is 650 nm. In this case, the condition of formula 1 is satisfied and $EQE(\lambda_2) \times (1 - 0.46n^{-2.8}) \times \eta = EQE(\lambda_1)$ is held.

In the example shown in FIG. 4, when the quantum efficiency $\eta$ of the wavelength conversion substances 30 is 1, the absorption long-wavelength edge ($\lambda_1$) may be set to 500 nm or less. In this case, the condition of formula 1 is satisfied. That is, as $\eta$ approaches 1, the absorption long-wavelength edge ($\lambda_1$) can be shifted closer to the long-wavelength side. On the other hand, as $\eta$ becomes smaller, the absorption long-wavelength edge ($\lambda_1$) needs to be shifted closer to the short wavelength side.

In the example shown in FIG. 4, when the ultraviolet absorbing substances 31 (for example, a triazine compound (Tinuvin 1600 manufactured by BASSF, etc.)) are contained, the external quantum efficiency of the module starts to decrease at around the wavelength of 400 nm and reaches substantially 0 at around the wavelength of 350 nm, as compared to the case where the ultraviolet-absorbing substances 31 are not contained. That is, most of incident light having a wavelength of 350 nm or lower is absorbed by Tinuvine 1600. When the wavelength conversion substances 30 and the ultraviolet-absorbing substances 31 are used in combination, the substances compete with each other in absorbing ultraviolet rays. Thus, the absorption wavelengths of the wavelength conversion substances 30 are preferably set depending on the absorption wavelengths of the ultraviolet-absorbing substances 31.

In the solar cell module 10 provided with the a-Si:H cells, when Tinuvin 1600 is used as the ultraviolet-absorbing substances 31, the encapsulant 14a may be separated into two layers such that, for example, the first protection member 12 side is provided with a layer containing the wavelength conversion substances 30, and the solar cell 11 side is provided with a layer containing the ultraviolet-absorbing substances 31.

In the example shown in FIG. 5, the quantum efficiency $\eta$ of the wavelength conversion substances 30 is 1, and the refractive index n of the first encapsulant 14a is 1.5 (that is, $0.46n^{-2.8} = 0.15$). The absorption long-wavelength edge ($\lambda_1$) of the wavelength conversion substances 30 is 420 nm, and the emission peak wavelength ($\lambda_2$) is 450 nm. Also in this case, the condition of formula 1 is satisfied and $EQE(\lambda_2) \times (1 - 0.46n^{-2.8}) \times \eta = EQE(\lambda_1)$ is held.

When the condition of formula 1 is satisfied, the external quantum efficiency of the solar cell module 10 is improved as a result of addition of the wavelength conversion substances 30. Thus, the lower limit value of $EQE(\lambda_1)$ is not limited to a particular value. As shown in FIGS. 4 and 5, in order to efficiently utilize the wavelength conversion substances 30 and improve the external quantum efficiency of the solar cell module 10, the condition of $EQE(\lambda_2) \times \alpha = EQE(\lambda_1)$ is most suitable. Here, $EQE(\lambda_2) \times \alpha$ being equal to $EQE(\lambda_1)$ is intended to include a range in which $EQE(\lambda_2) \times \alpha$ is considered to be substantially equal to $EQE(\lambda_1)$. More specifically, the difference between these values may be within about $\pm 5\%$.

When the solar cells 11 are the a-Si:H cells, specific examples of the wavelength conversion substances 30 which satisfy the condition of formula 1 include TBPe (2,5,8,11-Tetra-tert-butylperylene) and BCzVBi (4,4'-Bis(9-ethyl-3-carbazovinylene)-1,1'-biphenyl). The concentration of the wavelength conversion substances 30 in the encapsulant 14a is not limited to a particular value. The concentration is, for example, 0.1 to 15 wt%, when the wavelength conversion substances 30 are inorganic wavelength conversion substances. The concentration is, for example, 0.02 to 2.0 wt%, when the wavelength conversion substances 30 are organic wavelength conversion substances.

FIG. 6 is a sectional view of a solar cell module 10x which is another example of the embodiment.

As illustrated in FIG. 6, the solar cell module 10x includes solar cells each having a different structure from those in the solar cell module 10. A photoelectric conversion unit 40 of a solar cell 11x illustrated in FIG. 6 includes a p-type single-crystal silicon substrate 41, and an n-type layer 42 formed by diffusing phosphor (P) onto the substrate at a high temperature. Electrodes 43, 44 are formed on the light-receiving surface and the back surface of the photoelectric conversion unit 40, respectively. The solar cell 11x is referred to as a "diffusion cell," in general.

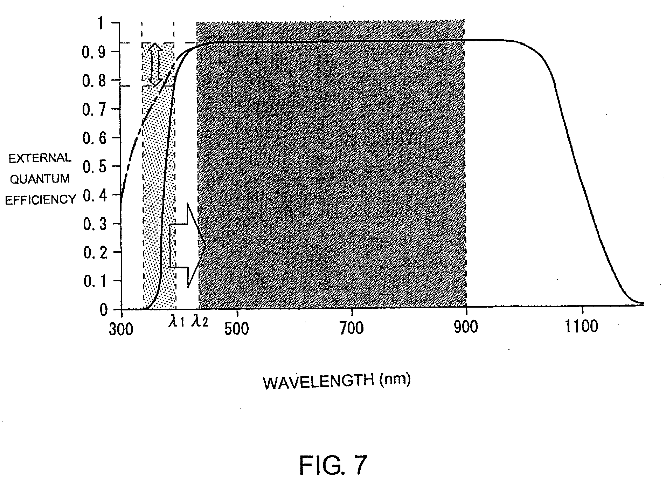

FIG. 7 is a diagram showing one specific example in which the condition of formula 1 is satisfied in the solar cell module 10x provided with the above diffusion cells (wherein the quantum efficiency $\eta$ of the wavelength conversion substances 30 is 1, and the refractive index n of the encapsulant 14a is 1.5). As shown in FIG. 7, in the case of the diffusion cells, the external quantum efficiency is high when the wavelength is within a range of 430 to 1000 nm. On the other hand, the external quantum efficiency is low when the wavelength is shorter than the wavelength of 430 nm or longer than the wavelength of 1000 nm. Accordingly, the absorption wavelengths of the wavelength conversion substances 30 are preferably lower than 430 nm and the emission wavelengths of the wavelength conversion substances 30 are preferably 430 to 1000 nm. Further, the absorption long-wavelength edge ($\lambda_1$) is preferably 350 to 390 nm, and the emission peak wavelength ($\lambda_2$) is not less than a value (e.g., 430 nm) obtained by adding 20 nm to the long-wavelength edge ($\lambda_1$) but is 1000 nm or lower, in consideration of the condition of formula 1.

In the example shown in FIG. 7, the absorption long-wavelength edge ($\lambda_1$) of the wavelength conversion substances 30 is 390 nm, and the emission peak wavelength ($\lambda_2$) is 430 nm. In this case, the condition of formula 1 is satisfied and $EQE(\lambda_2) \times (1 - 0.46n^{-2.8}) \times \eta = EQE(\lambda_1)$ is held. When the emission peak wavelength ($\lambda_2$) is 430 nm, the absorption long-wavelength edge ($\lambda_1$) is set to 390 nm or less to satisfy the condition of formula 1.

When the above diffusion cells are used, specific examples of the wavelength conversion substances 30 which satisfy the condition of formula 1 include DPAVB (4-(Di-p-tolylamino)-4'-[(di-p-tolylamino)styryl]stilbene). SiC-based cells having heterojunctions and having a band gap of 2.2 to 3.0 eV also provide an external quantum efficiency curve similar to that of the above diffusion cells.

The solar cell module 10 having the above configuration is preferably manufactured through a lamination step in which the component members are laminated and thermocompression is performed on the laminate. In the manufacturing process for the solar cell module 10, first, the solar cells 11 (the a-Si:H cells) are manufactured. The a-Si:H cells can be manufactured by a known method. The wiring materials 15 are attached onto the electrodes of the solar cells 11, the plurality of solar cells 11 are connected with one another in series, and the string of the solar cells 11 is manufactured.

Next, the resin sheet forming the encapsulant 14a is laminated on the first protection member 12, and the string of the solar cells 11 is laminated on the encapsulant 14a. Further, the resin sheet forming the encapsulant 14b is laminated on the string of the solar cells 11, and the second protection member 13 is laminated on the encapsulant 14b. The wavelength conversion substances 30 are added to at least the resin sheet forming the encapsulant 14a. This laminate is heated to about 150°C in a vacuum state, for example. Subsequently, heating is continued while the component members are being pressed against a heater under the atmospheric pressure so that the resin components of the resin sheets are crosslinked. Thus, a solar cell panel is obtained. Finally, a frame, etc. is attached to the solar cell panel, and thus, the solar cell module 10 is manufactured.

That is, the manufacturing steps for the solar cell module 10 include the following steps:

(1) a first step of preparing the solar cells 11, the first protection member 12, and the second protection member 13;
(2) a second step of preparing the encapsulants 14a and 14b which seal the solar cells 11; and
(3) a third step of sequentially overlapping and laminating the first protection member 12, the encapsulant 14a, the solar cells 11, the second encapsulant 14b, and the second protection member 13.

In the second step, the wavelength conversion substances 30 are selected on the basis of formula 1.

$$[\text{Formula 1}]\ EQE(\lambda_2) \times (1 - 0.46n^{-2.8}) \times \eta \geq EQE(\lambda_1)$$

The wavelength conversion substances 30 satisfying the condition of formula 1 are selected and added to the encapsulant 14a. As a result, the external quantum efficiency is improved at the absorption wavelength of the wavelength conversion substances 30 and the utilization efficiency of incident light can be improved. In the a-Si:H cells, as described above, the external quantum efficiency is high when the wavelength is within a range of 650 to 1000 nm. When the wavelength is shorter than 650 nm or longer than 1000 nm, the external quantum efficiency is low (see FIG. 3). Accordingly, the wavelength conversion substances 30 having the emission wavelength within a range of 650 to 1000 nm are preferably used. The emission peak wavelength ($\lambda_2$) is preferably within a range of 650 to 1000 nm.

When the emission peak wavelength ($\lambda_2$) is 650 to 1000 nm, the condition of formula 1 can be satisfied by using the wavelength conversion substances 30 having the absorption long-wavelength edge ($\lambda_1$) within a range of 350 to 500 nm. More specifically, when the quantum efficiency $\eta$ of the wavelength conversion substances 30 is 0.8, the emission peak wavelength ($\lambda_2$) is 650 nm, and the refractive index n of the first encapsulant 14a is 1.5, the wavelength conversion substances 30 are required to have the absorption long-wavelength edge ($\lambda_1$) of 440 nm or lower. In the second step, the wavelength conversion substances 30 (the wavelength conversion substances 30 having the absorption long-wavelength edge ($\lambda_1$) of approximately 440 nm) are particularly preferably selected so as to satisfy $EQE(\lambda_2) \times (1 - 0.46n^{-2.8}) \times \eta = EQE(\lambda_1)$.

When the diffusion cells are used, the wavelength conversion substances 30 are selected also based on the condition of formula 1. The wavelength range which has the high external quantum efficiency in the case where the diffusion cells are used differs from that in the case where the a-Si:H cells are used. Accordingly, the suitable emission peak wavelength ($\lambda_2$) and the suitable absorption long-wavelength edge ($\lambda_1$) of the wavelength conversion substances 30 differ from those in the case of using the a-Si:H cells. To configure the solar cell module, setting the emission peak wavelength ($\lambda_2$) within a range which has high external quantum efficiency is preferably followed by selecting the wavelength conversion substances 30 having the absorption long-wavelength edge ($\lambda_1$) within a range which satisfies the condition of formula 1.

REFERENCE SIGNS LIST

10 SOLAR CELL MODULE, 11 SOLAR CELL, 12, FIRST PROTECTION MEMBER, 13 SECOND PROTECTION MEMBER, 14, 14a, 14b ENCAPSULANT, 15 WIRING MATERIAL, 20 PHOTOELECTRIC CONVERSION UNIT, 21 SUBSTRATE, 22, 23 AMORPHOUS SEMICONDUCTOR LAYER, 24, 25 TRANSPARENT CONDUCTIVE LAYER, 30 WAVELENGTH CONVERSION SUBSTANCE, 31 ULTRAVIOLET-ABSORBING SUBSTANCE

**Claims**

1. A solar cell module comprising:

   a solar cell;
   a first protection member that is arranged on a light-receiving surface side of the solar cell;
   a second protection member that is arranged on a back surface side of the solar cell;
   an encapsulant that includes a first encapsulant arranged between the solar cell and the first protection member and a second encapsulant arranged between the solar cell and the second protection member and that seals the solar cell; and
   a wavelength conversion substance that is contained in the first encapsulant and that absorbs light having a particular wavelength and converts the wavelength, wherein
   the condition of formula 1 is satisfied,

   $$[\text{Formula 1}]\ \mathrm{EQE}(\lambda_2) \times (1 - 0.46\mathrm{n}^{-2.8}) \times \eta \geq \mathrm{EQE}(\lambda_1),$$

   where $\mathrm{EQE}(\lambda_1)$ represents an external quantum efficiency of the module at the absorption long-wavelength edge ($\lambda_1$) of the wavelength conversion substance, $\mathrm{EQE}(\lambda_2)$ represents an external quantum efficiency of the module at the emission peak wavelength ($\lambda_2$) of the wavelength conversion substance, n represents a refractive index of the first encapsulant, and $\eta$ represents a quantum efficiency of the wavelength conversion substance.

2. The solar cell module according to claim 1, wherein
   the solar cell has a photoelectric conversion unit that includes a single-crystal silicon substrate and an amorphous silicon layer formed on the substrate.

3. The solar cell module according to claim 2, wherein
   the wavelength conversion substance has an absorption long-wavelength edge ($\lambda_1$) of 350 to 500 nm and an emission peak wavelength ($\lambda_2$) of 650 to 1000 nm.

4. A solar cell module comprising:

   a solar cell that has a photoelectric conversion unit including a single-crystal silicon substrate and an amorphous silicon layer formed on the substrate;
   a first protection member that is arranged on a light-receiving surface side of the solar cell;
   a second protection member that is arranged on a back surface side of the solar cell;
   an encapsulant that includes a first encapsulant arranged between the solar cell and the first protection member and a second encapsulant arranged between the solar cell and the second protection member, and that seals the solar cell; and
   a wavelength conversion substance that is contained in the first encapsulant and that absorbs light having a particular wavelength and converts the wavelength, wherein
   the wavelength conversion substance has an absorption long-wavelength edge ($\lambda_1$) of 350 to 500 nm, and an emission peak wavelength ($\lambda_2$) which is not less than a value obtained by adding 20 nm to the absorption long-wavelength edge ($\lambda_1$) but 1000 nm or less.

5. A method for manufacturing a solar cell module, comprising:

   a first step of preparing a solar cell, a first protection member, and a second protection member;
   a second step of preparing first and second encapsulants which seal the solar cell; and
   a third step of sequentially overlapping and laminating the first protection member, the first encapsulant, the solar cell, the second encapsulant, and the second protection member, wherein
   a wavelength conversion substance that absorbs light having a particular wavelength and converts the wavelength is added to the first encapsulant, and
   in the second step, the wavelength conversion substance to be added to the first encapsulant is selected on the basis of formula 1,

$$[\text{Formula 1}] \quad EQE(\lambda_2) \times (1 - 0.46n^{-2.8}) \times \eta \geq EQE(\lambda_1),$$

where $EQE(\lambda_1)$ represents an external quantum efficiency of the module at the absorption long-wavelength edge ($\lambda_1$) of the wavelength conversion substance, $EQE(\lambda_2)$ represents an external quantum efficiency of the module at the emission peak wavelength ($\lambda_2$) of the wavelength conversion substance, n represents a refractive index of the first encapsulant, and $\eta$ represents a quantum efficiency of the wavelength conversion substance.

6. The method for manufacturing a solar cell module according to claim 5, wherein
the solar cell has a photoelectric conversion unit that includes a single-crystal silicon substrate and an amorphous silicon layer formed on the substrate.

7. The method for manufacturing a solar cell module according to claim 6, wherein
the wavelength conversion substance has an absorption long-wavelength edge ($\lambda_1$) of 350 to 500 nm, and an emission peak wavelength ($\lambda_2$) of 650 to 1000 nm.

FIG. 1

FIG. 2

WAVELENGTH (nm)

FIG. 3

WAVELENGTH (nm)

FIG. 4

FIG. 5

FIG. 6

FIG. 7

## INTERNATIONAL SEARCH REPORT

| International application No. |
| --- |
| PCT/JP2015/002623 |

**A. CLASSIFICATION OF SUBJECT MATTER**
*H01L31/055*(2014.01)i, *H01L31/048*(2014.01)i, *H01L31/0747*(2012.01)i

According to International Patent Classification (IPC) or to both national classification and IPC

**B. FIELDS SEARCHED**

Minimum documentation searched (classification system followed by classification symbols)
H01L31/055, H01L31/048, H01L31/0747

Documentation searched other than minimum documentation to the extent that such documents are included in the fields searched
| | | | |
| --- | --- | --- | --- |
| Jitsuyo Shinan Koho | 1922–1996 | Jitsuyo Shinan Toroku Koho | 1996–2015 |
| Kokai Jitsuyo Shinan Koho | 1971–2015 | Toroku Jitsuyo Shinan Koho | 1994–2015 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 2012-69865 A (Toppan Printing Co., Ltd.),<br>05 April 2012 (05.04.2012),<br>paragraph [0033]<br>(Family: none) | 1-2<br>3-4<br>5-7 |
| Y | JP 2011-222748 A (Hitachi Chemical Co., Ltd.),<br>04 November 2011 (04.11.2011),<br>fig. 4<br>& US 2013/0080116 A1    & WO 2011/126117 A1<br>& EP 2557600 A1    & TW 201202387 A<br>& CN 102834931 A    & KR 10-2012-0130257 A | 3 |
| Y | WO 2014/088014 A1 (Asahi Glass Co., Ltd.),<br>12 June 2014 (12.06.2014),<br>paragraph [0061]<br>(Family: none) | 4 |

☒ Further documents are listed in the continuation of Box C.   ☐ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| 15 June 2015 (15.06.15) | 30 June 2015 (30.06.15) |

| Name and mailing address of the ISA/ | Authorized officer |
| --- | --- |
| Japan Patent Office<br>3-4-3,Kasumigaseki,Chiyoda-ku,<br>Tokyo 100-8915,Japan | Telephone No. |

Form PCT/ISA/210 (second sheet) (July 2009)

**INTERNATIONAL SEARCH REPORT**

International application No.

PCT/JP2015/002623

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2013-65595 A (Hitachi Chemical Co., Ltd.), 11 April 2013 (11.04.2013), paragraphs [0013] to [0015] (Family: none) | 1-7 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011155614 A